# EUROPEAN PATENT SPECIFICATION

(11) **EP 1 595 240 B1**
(45) Date of publication and mention of the grant of the patent: **15.10.2008**
(21) Application number: 04706481.1
(22) Date of filing: 29.01.2004
(51) Int. Cl.: G09F 9/33

(54) **INTEGRATED LOW PROFILE DISPLAY**
INTEGRIERTES DISPLAY MIT NIEDRIGEM PROFIL
AFFICHEUR MINCE INTEGRE

(30) Priority: 30.01.2003 US 443651 P; 22.01.2004 US 764170
(43) Date of publication of application: 16.11.2005
(73) Proprietor: TouchSensor Technologies, L.L.C., Wheaton, Illinois 60187 (US)
(72) Inventor: WADIA, Bahar, N., Bartlett, IL 60103 (US); CALDWELL, David, W., Holland, MI 49424 (US)
(74) Representative: Hackett, Sean James
(86) International application number: PCT/US2004/002510
(87) International publication number: WO 2004/068448

(56) References cited:
- EP-A- 0 884 786
- DE-B- 1 099 403
- FR-A- 2 651 356
- GB-A- 1 585 392
- US-A- 5 226 723

## Description

### CROSS REFERENCE TO RELATED APPLICATIONS

This application claims priority from United States Provisional Patent Application Serial No. 60/443,551, filed on January 30, 2003.

### BACKGROUND OF THE INVENTION

### 1. The Technical Field

The present invention relates generally to displays used in man/machine interfaces. More particularly, the present invention relates to integration of such displays into wiring boards, equipment panels and other substrates.

### 2. The Prior Art

Displays often are used to visually communicate information to a user of machines as diverse as coffee makers and industrial presses. Such displays can be embodied in many forms. For example, a simple display might take the form of one or more lights that illuminate selectively to indicate the status of a machine (*e.g*., energized, running, stopped). A more complex display might include one or more multi-segment or dot matrix elements for providing alphanumeric information (*e.g*., temperature, pressure, time). A conventional display typically is provided as a pre-manufactured component or sub-assembly for later mounting to a carrier or substrate, typically a printed wiring board or other component or panel of a machine. The substrate or carrier may include other include electrical/electronic components, for example, proximity sensors.

Conventional displays can be complicated and expensive to build. Indeed some applications might even require custom-made displays. This can make them unsuitable for low-cost applications. Also, conventional displays have a finite thickness. When mated to a machine panel or other substrate, even a relatively thin conventional display might be too thick for integration into an application requiring a low overall profile. Examples of prior art light emitting display panels include FR 2 651 356 (Thomson-CSF), GB 1 585 392 (International Vibration Engineering) and US-A-5 226 723 (Der-Jong Chen).

### SUMMARY OF THE INVENTION

The present invention overcomes these and other shortcomings of the prior art by integrating a display into a component carrier or substrate, for example, a printed wiring board or panel of an apparatus in connection with which the display is to be used, thus obviating the need for a separate display component. Other components, such as sensors, can be integrated into the assembly, as well. Without limitation, sensors as described in U.S. Patents No. 5,594,222, No. 6,310,611 and No. 6,320,282, are well suited for such an application.

In a preferred embodiment, the substrate is of substantially uniform thickness and relatively thin compared to its length and width. However, the substrate may embody any other shape and cross section, as well. Thus, the first and second surfaces may be, but need not be, substantially parallel. The substrate typically would be embodied as a printed wiring board, but could be embodied in any other number of other forms. For example, the substrate could be an exterior panel of an appliance or the dash panel of an automobile. In a preferred embodiment, the substrate defines one or more penetrations therethrough, each such penetration having a side wall, an entrance opening and an exit opening. The penetration can be of any regular or irregular shape, for example, round, square or elliptical, and it can be formed using any suitable molding, forming or machining technique, for example, NC drilling or punching, among others. A light source is associated with the entrance opening and is configured to selectively direct or otherwise admit light to the penetration through the entrance opening. Preferred light sources include lamps, LEDs, OLEDs, PLEDs, though others can be used, as well.

The penetration serves as a light guide. To this end, the side wall of the penetration preferably is coated with a reflective material, for example, white paint or a reflective metal, so that light introduced to the penetration is transmitted therethrough and not dissipated into the substrate. In other embodiments, the side wall could be coated with any substantially opaque material which precludes diffusion of light into the substrate. Further, the side wall could be left uncoated if the substrate were made of a material which does not substantially transmit light. In the foregoing embodiments, light entering the penetration at the entrance opening reflects off the side wall and exits the penetration at the exit opening. Alternatively, the penetration serves as a housing for a light guide. In such a preferred embodiment, the penetration is substantially filled with a material having a high refractive index, for example, a light transmissive epoxy having good optical properties. In this embodiment, light entering the refractive material from the entrance opening reflects off the internal walls of the refractive material and exits the refractive material at the exit opening. Thus, the refractive material acts as a light guide. In another embodiment, a discrete light guide could be installed in the penetration.

In a preferred embodiment, a light diffuser is associated with the exit opening of the penetration. The diffuser diffuses light exiting the penetration to enhance readability of the display by the user. Such light diffuser typically would be embodied as a layer of light transmissive material applied over the exit opening.

In an alternate embodiment, the substrate defines one or more cavities, instead of (or in addition to) the foregoing penetrations. Each cavity includes a side wall and an entrance opening. Such cavities do not completely penetrate the substrate. Thus, each cavity includes a closed end instead of an exit opening. These cavities can be molded into the substrate or formed into the substrate using any suitable machining technique. In this embodiment, at least the portion of the substrate between the closed end of the cavity and the second surface of the substrate is transparent or translucent so that light may be transmitted therethrough. The side wall of the cavity preferably is coated in the manner discussed above to preclude light dispersion into the substrate. Alternatively, the cavity can be filled with a refractive material, as discussed above. In this embodiment, the portion of the substrate between the closed end of the cavity and the second surface of the substrate performs the function of the light diffuser of the embodiment described above.

A display according to the invention can mimic conventional single element or multiple element displays. Typically, a single penetration or cavity would be used to mimic a single element display, such as a status indicator light, or the individual elements of a multiple element display. For example, seven penetrations or cavities arranged in the manner of a conventional seven-segment display could mimic such a conventional display. Other configurations are possible, as well. Further, any practical number of displays can be located on the same substrate. Thus, the present invention is well-suited to applications requiring multiple displays.

The substrate can include other components commonly present in man/machine interfaces, such as sensors and other electrical or electronic components. Integration of such components with the display can further reduce the cost, complexity, and size of an end component. The substrate also can include decoration, texture, and the like, for functional or purely decorative purposes.

### BRIEF DESCRIPTION OF THE DRAWINGS

FIG. 1A is a cross-sectional view of an embodiment of the present invention;
FIG. 1B is a top plan view of the apparatus illustrated in FIG. 1A;
FIG. 2 is a cross-sectional view of an alternate embodiment of the present invention;
FIG. 3 is a cross-sectional view of another alternate embodiment of the present invention; and
FIG. 4 is a cross-sectional view of a further embodiment of the present invention.

### DETAILED DESCRIPTION OF THE ILLUSTRATED EMBODIMENTS

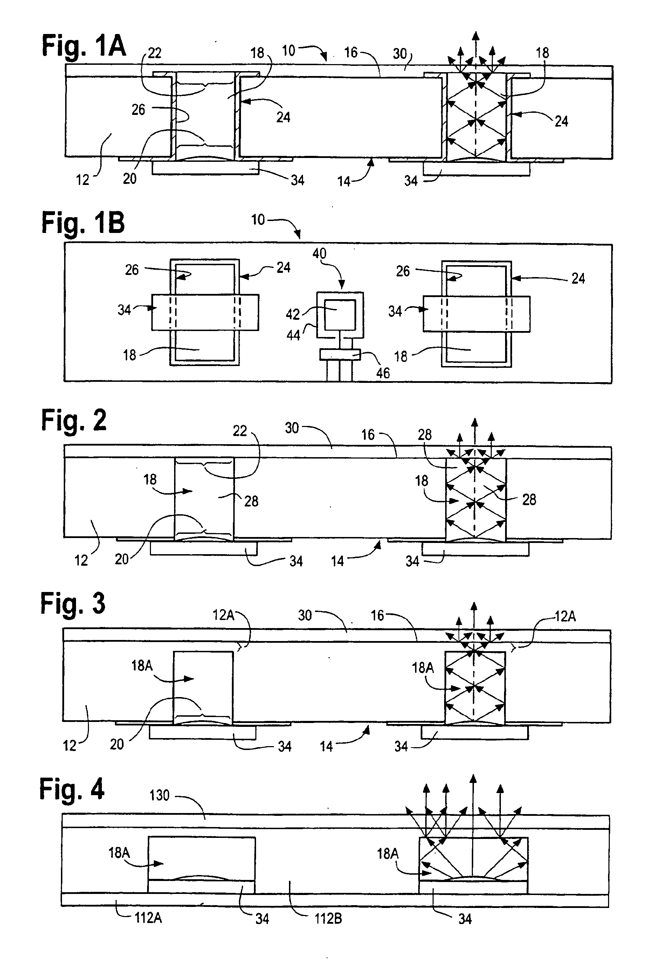

FIGS. 1A and 1B illustrate a preferred embodiment of an integrated display 10 according to the present invention. Display 10 includes a substrate 12 having a first surface 14 and a second surface 16. Substrate 12 can be embodied as virtually any type of substrate, carrier, panel, etc. Although illustrated as planar and having uniform thickness, substrate 12 can take any virtually any other form. For example, it can have regularly or irregularly varying non-uniform thickness. It can be curved, rippled, or have any variety of complex shapes and cross-sections. In a typical embodiment, substrate 12 might be a printed wiring board, such as an FR4 board with a one-half ounce copper layer and an OSP or HASL finish. In other embodiments, substrate 12 could be an exterior panel of a domestic appliance, such as a coffee maker or washing machine, a dash panel or other interior panel of an automobile, or a panel of any other machine or piece of equipment. These are but a few examples of substrates into which a display can be integrated according to the present invention. Further, although first surface 14 and second surface 16 are illustrated as generally opposed, parallel surfaces, first and second surfaces 14 and 16 could be related in any number of other ways. For example, first and second surfaces 14 and 16 could be at right angles to each other.

Substrate 12, as illustrated in FIG. 1B, includes two rectangular penetrations 18. In other embodiments, substrate 12 may include more or fewer than two such penetrations, and such penetrations may be of any regular or irregular shape, including, without limitation, circular, square, elliptical or free form. Penetrations 18 may be formed by drilling, molding, punching, or other suitable techniques. Each penetration 18 includes an entrance opening 20, an exit opening 22 and a side wall 24.

Penetrations 18 function as light guides or housings for light guides. Light is coupled from a light source into entrance opening 20. The light reflects off of the internal walls of the light guides so that the light ultimately leaves the light guide at the exit opening.

In a preferred embodiment, as illustrated in FIG. 1A, penetrations 18 function as light guides. In order to best enable penetration 18 to function as a light guide, side wall 24 preferably is impervious to light transmission to prevent light dissipation or diffusion through substrate 12. To this end, side wall 24 preferably is plated with a reflective coating 26, as shown in FIG. 1A. In alternate embodiments, side wall 24 can be coated with, for example, white paint or other non-transparent materials. Conceivably, side wall 24 could be left uncoated. In such an embodiment, substrate 12 preferably would be made of a material which inherently reflects light or does not substantially transmit light because such materials would tend to reduce light dissipation through the substrate. In an alternate embodiment, as illustrated in FIG. 2, penetrations 18 function as housings for light guides. In this embodiment, penetrations 18 are filled with an epoxy material 28 having a high refractive index, with the epoxy material comprising the light guide. Such material allows light transmission though penetrations 18, from the first side to the second side of substrate 12, but prevents or retards light dispersion into substrate 12. Other materials having desirable optical, mechanical and electrical properties can be used in lieu of epoxy 28. In another embodiment, not shown in the drawings, a discrete light guide, such as a light pipe could be installed in penetration 18. In the foregoing embodiments, side wall 24 can be, but need not be coated as described above in connection with the FIG. 1A embodiment. A separate light pipe assembly with apertures built into it could serve as the light guide in a similar fashion.

A display according to the present invention can include a diffuser 30 located at or near exit opening 22. The purpose of diffuser 30 is to diffuse light exiting penetration 18 which might otherwise be channelized, thus enhancing readability of the display by the user. To this end, diffuser 30 can be made of any variety of light transmissive materials. In preferred embodiments, diffuser 30 can cover a substantial portion of second surface 16, as shown in FIGS. 1A and 2, or it can simply cover a smaller portion of second surface 16 proximate exit opening 22. Diffuser 30 can include printing or other decoration (not shown) to enhance the functionality of the display (and of any other components associated with the substrate), or for purely decorative purposes. Diffuser 30 can be embodied as, for example, a fascia, an overlay, a piece of glass, or any other structure that aids in diffusing light exiting penetration 18. Display 10 further includes a light source 34 adapted to introduce light to entrance opening 20, as shown in FIGS. 1A, 1B and 2. Preferably, light source 34 takes the form of a low profile LED mounted to first surface 14 of substrate 12, proximate entrance opening 20. In other embodiments, light source 34 could be a lamp, an EL, OLED, PLED, vacuum fluorescent or light source. Although light source LED is illustrated in a particular orientation with respect to penetration 18, other orientations are possible, as well.

In another embodiment illustrated in FIG. 3, substrate 12 defines one or more cavities 18A in lieu of (or in addition to) penetrations 18. Cavities 18A are similar to and provide essentially the same function as penetrations 18, except that cavities 18A do not completely penetrate substrate 12. Instead, a thin layer of substrate material 12A remains where exit opening 22 is located in the FIGS. 1A and 2 embodiments. Thus, each cavity 18A includes an entrance opening 20, a side wall 24 and a closed end 32. Side wall 24 of cavity 18A can be coated with a reflective or other non-transparent material (not shown), as discussed above, so that cavity 18A can function as a light guide. Alternatively, cavity 18A can be filled with a refractive material (not shown), as discussed above, which can function as a light guide. In such embodiments, at least thin layer of substrate material 12A is transparent or translucent so that light may be transmitted therethrough and be visible to the user. Thus, thin layer of substrate material 12A can function as a diffuser, obviating any need for a separate diffuser, such as diffuser 30 as illustrated in FIGS. 1A and 2 and described above. Notwithstanding, a separate diffuser 30 may be layered or screen-printed on surface 16.

In another alternate embodiment, illustrated in FIG. 4, the light source is disposed on a carrier, for example, a printed wiring board, separate from the substrate comprising the light guide. Here, light sources 34, for example, surface mount LEDs, are disposed on carrier 112A, which can include other components, such as sensors, as discussed above. Substrate 112B includes cavities 18A, as discussed above. In other embodiments, substrate 112B could include penetrations in addition to or in lieu of cavities 18A. Carrier 112A is attached to substrate 112B using adhesives or other suitable attachment means such that light sources 34 mounted on carrier 34 are substantially aligned with cavities 18A (and/or penetrations) in substrate 112B. An optional diffuser 130 can be attached to the viewed surface (here, the opposing surface) of substrate 112B, as described above.

In practice, a seven-segment display could be constructed by tooling (such as by punching or NC drilling) or molding a substrate (such as a printed wiring board) with penetrations corresponding to the seven segments, plating the side walls of the penetrations using known plating techniques, and attaching a suitable light source (such as a surface-mount LED of appropriate color) proximate the entrance opening of each penetration using a suitable technique (such as a reflow-solder technique, using known surface-mount component process equipment), opposite the exit opening and any diffuser or fascia that might be located proximate the exit opening. Other user interface components (such as sensors or other components) could be mounted to the substrate at the same time or as a step during the same production process, thus reducing overall manufacturing cost and yielding an interface of smaller size than could be manufactured using conventional discrete components. For example, a sensor 40 can be mounted on the first surface 14 of substrate 12, as shown in FIG. 1B. A sensor could be mounted on other portions of display 10 as well. The illustrated sensor 40 includes a first electrode 42, a second electrode 44, and an active component or integrated circuit 46. Other types of sensors or components could be used instead of or in addition to the illustrated sensor. In another embodiment, the penetrations could be filled with a material, such as an epoxy, having an appropriate refractive index, in lieu of plating. In further embodiment, the substrate could be tooled or molded with cavities instead of penetrations, the penetrations could be filled with a refractive material or the side walls thereof could be plated.

The present invention is limited only by the following claims and not the foregoing embodiments. One skilled in the art would know to make certain modifications to the foregoing embodiments without departing from the scope of the claims.

## Claims

1. An integrated low profile display apparatus (10), comprising:
a substrate (12) having a first surface (14) and a second surface (16);
said substrate (12) defining at least one penetration (18) extending through said substrate from said first surface to said second surface;
each said penetration (18) having a side wall (24), an entrance opening (20) defined by said first surface, and an exit opening (22) defined by said second surface;
at least one light emitting device (34); and
a light diffuser (30) associated with said exit opening (22) of said penetration;
each said light emitting device mounted to said first surface (14) of said substrate (12) proximate the entrance opening (20) of a corresponding penetration (18) and adapted to selectively admit light to said penetration via said entrance opening; and
each said light emitting device (34) being electrically connected to a corresponding electrical conductor disposed on said substrate.

2. The apparatus of claim 1 wherein said diffuser (30) comprises a layer of light transmissive material applied over said exit opening.

3. The apparatus of claim 1 wherein said display (10) comprises a single element defined by a single penetration (18).

4. The apparatus of claim 1 wherein the display (10) comprises plural elements defined by plural penetrations (18).

5. The apparatus of claim 1 further comprising at least one electronic component mounted on said substrate (12).

6. The apparatus of claim 5 wherein said electronic component comprises a sensor (40).

7. An integrated low profile display apparatus (10), comprising:
a substrate (12) having a first surface (14) and a second surface (16);
said substrate (12) defining at least one cavity (18A);
said cavity (18A) having a substantially opaque side wall (24), an entrance opening (20) defined by said first surface, and a closed end (32); and
at least one light emitting device (34),
each said light emitting device (34) mounted to said first surface (14) of said substrate (12) proximate the entrance opening (20) of a corresponding cavity (18A) and adapted to selectively admit light to said cavity via said entrance opening; and each said light emitting device (34) being electrically connected to a corresponding electrical conductor disposed on said substrate.

8. The apparatus of claim 1 or claim 7 wherein said substrate (12) is of substantially uniform thickness.

9. The apparatus of claim 1 or claim 7 wherein said substrate (12) is of varying cross-section.

10. The apparatus of claim 1 or claim 7 wherein said substrate (12) comprises a printed wiring board (112A).

11. The apparatus of claim 1 or claim 7 wherein said substrate (12) comprises a user interface panel.

12. The apparatus of claim 1 or claim 7 wherein said side wall (24) is covered with a substantially opaque material.

13. The apparatus of claim 12 wherein said substantially opaque material is a reflective material.

14. The apparatus of claim 13 wherein said reflective material is a paint.

15. The apparatus of claim 13 wherein said reflective material is a reflective coating.

16. The apparatus of claim 1 of claim 7 further comprising a light guide within said penetration or cavity.

17. The apparatus of claim 16 wherein said light guide comprises a material having a high index of refraction.

18. The apparatus of claim 17 wherein said material having a high index of refraction comprises a light transmissive expoxy.

19. The apparatus of claim 16 wherein said substrate comprises a substantially opaque material.

20. The apparatus of claim 16 wherein said substrate comprises a material substantially impervious to light transmission.

21. The apparatus of claim 7 further comprising a light diffuser (30) associated with said closed end (12A) of said cavity (18A).

22. The apparatus of claim 21 wherein said diffuser (30) comprises a layer of light transmissive material applied over said closed end of said cavity.

23. The apparatus of claim 1 or claim 7 wherein said light emitting device (34) comprises a light emitting diode.

24. The apparatus of claim 1 or claim 7 wherein said light emitting device (34) comprises a lamp.

25. The apparatus of claim 1 or claim 7 wherein said light emitting device (34) comprises on OLED.

26. The apparatus of claim 1 or claim 7 wherein said light emitting device (34) comprises a PLED.

27. The apparatus of claim 7 wherein said display (10) comprises a single element defined by a single cavity (18A).

28. The apparatus of claim 7 wherein said display (10) comprises plural elements defined by plural cavities (18A).

29. The apparatus of claim 7 further comprising at least one sensor (40) mounted on said substrate.

30. The apparatus of claim 6 or claim 29 wherein said sensor (40) comprises at least a first electrode (42) disposed on said substrate (12).

31. The apparatus of claim 30 wherein said sensor (40) further comprises a second electrode (44) disposed on said substrate (12).

32. The apparatus of claim 30 wherein said sensor (40) further comprises an active component (46) electrically coupled to said first electrode (42).

33. The apparatus of claim 30 wherein said sensor (40) further comprises an integrated control circuit (46) electrically coupled to said first electrode (42).

## Patentansprüche

1. Integrierte flache Display-Vorrichtung (10), die aufweist:
ein Substrat (12) mit einer ersten Oberfläche (14) und einer zweiten Oberfläche (16),
wobei das Substrat (12) mindestens eine Durchdringung (18) definiert, die sich durch das Substrat von der ersten Oberfläche zur zweiten Oberfläche erstreckt,
wobei jede Durchdringung (18) eine Seitenwand (24), eine Eintrittsöffnung (20), die durch die erste Oberfläche definiert wird, und eine Austrittsöffnung (22) aufweist, die durch die zweite Oberfläche definiert wird;
mindestens eine Lichtemissionsvorrichtung (34); und
einen Lichtdiffusor (30), der mit der Austrittsöffnung (22) der Durchdringung verbunden ist,
wobei jede Lichtemissionsvorrichtung auf der ersten Oberfläche (14) des Substrates (12) in unmittelbarer Nähe der Eintrittsöffnung (20) einer entsprechenden Durchdringung (18) montiert wird und so ausgeführt ist, dass Licht selektiv zur Durchdringung über die Eintrittsöffnung zugelassen wird; und
wobei die Lichtemissionsvorrichtung (34) mit einem entsprechenden elektrischen Leiter, der auf dem Substrat angeordnet ist, elektrisch verbunden wird.

2. Vorrichtung nach Anspruch 1, bei der der Diffusor (30) eine Schicht des lichtdurchlässigen Materials aufweist, die über die Austrittsöffnung aufgebracht wird.

3. Vorrichtung nach Anspruch 1, bei der das Display (10) ein einzelnes Element aufweist, das durch eine einzelne Durchdringung (18) definiert wird.

4. Vorrichtung nach Anspruch 1, bei der das Display (10) mehrere Elemente aufweist, die durch mehrere Durchdringungen (18) definiert werden.

5. Vorrichtung nach Anspruch 1, die außerdem mindestens ein elektronisches Bauteil aufweist, das auf dem Substrat (12) montiert wird.

6. Vorrichtung nach Anspruch 5, bei der das elektronische Bauteil einen Sensor (40) aufweist.

7. Integrierte flache Display-Vorrichtung (10), die aufweist:
ein Substrat (12) mit einer ersten Oberfläche (14) und einer zweiten Oberfläche (16),
wobei das Substrat (12) mindestens einen Hohlraum (18A) definiert,
wobei der Hohlraum (18A) eine im Wesentlichen undurchlässige Seitenwand (24), eine Eintrittsöffnung (20), die durch die erste Oberfläche definiert wird, und ein geschlossenes Ende (32) aufweist; und
mindestens eine Lichtemissionsvorrichtung (34),
wobei jede Lichtemissionsvorrichtung (34) auf der ersten Oberfläche (14) des Substrates (12) in unmittelbarer Nähe der Eintrittsöffnung (20) eines entsprechenden Hohlraumes (18A) montiert wird und so ausgeführt ist, dass Licht selektiv zum Hohlraum über die Eintrittsöffnung zugelassen wird; und wobei die Lichtemissionsvorrichtung (34) mit einem entsprechenden elektrischen Leiter, der auf dem Substrat angeordnet ist, elektrisch verbunden wird.

8. Vorrichtung nach Anspruch 1 oder Anspruch 7, bei der das Substrat (12) eine im Wesentlichen gleichmäßige Dicke aufweist.

9. Vorrichtung nach Anspruch 1 oder Anspruch 7, bei der das Substrat (12) einen sich verändernden Querschnitt aufweist.

10. Vorrichtung nach Anspruch 1 oder Anspruch 7, bei der das Substrat (12) eine Leiterplatte (112A) aufweist.

11. Vorrichtung nach Anspruch 1 oder Anspruch 7, bei der das Substrat (12) eine Benutzerschnittstellenschalttafel aufweist.

12. Vorrichtung nach Anspruch 1 oder Anspruch 7, bei der die Seitenwand (24) mit einem im Wesentlichen undurchlässigen Material bedeckt ist.

13. Vorrichtung nach Anspruch 12, bei der das im Wesentlichen undurchlässige Material ein reflektierendes Material ist.

14. Vorrichtung nach Anspruch 13, bei der das reflektierende Material eine Farbe ist.

15. Vorrichtung nach Anspruch 13, bei der das reflektierende Material eine reflektierende Beschichtung ist.

16. Vorrichtung nach Anspruch 1 oder Anspruch 7, die außerdem einen Lichtleiter innerhalb der Durchdringung oder des Hohlraumes aufweist.

17. Vorrichtung nach Anspruch 16, bei der der Lichtleiter ein Material mit einem hohen Brechungsindex aufweist.

18. Vorrichtung nach Anspruch 17, bei der das Material mit einem hohen Brechungsindex ein lichtdurchlässiges Epoxid aufweist.

19. Vorrichtung nach Anspruch 16, bei der das Substrat ein im Wesentlichen undurchlässiges Material aufweist.

20. Vorrichtung nach Anspruch 16, bei der das Substrat ein Material aufweist, das im Wesentlichen undurchlässig für eine Lichtübertragung ist.

21. Vorrichtung nach Anspruch 7, das außerdem einen Lichtdiffusor (30) aufweist, der mit dem geschlossenen Ende (12A) des Hohlraumes (18A) verbunden ist.

22. Vorrichtung nach Anspruch 21, bei der der Diffusor (30) eine Schicht aus lichtdurchlässigem Material aufweist, das über dem geschlossenen Ende des Hohlraumes aufgebracht ist.

23. Vorrichtung nach Anspruch 1 oder Anspruch 7, bei der die Lichtemissionsvorrichtung (34) eine Lichtemissionsdiode aufweist.

24. Vorrichtung nach Anspruch 1 oder Anspruch 7, bei der die Lichtemissionsvorrichtung (34) eine Lampe aufweist.

25. Vorrichtung nach Anspruch 1 oder Anspruch 7, bei der die Lichtemissionsvorrichtung (34) ein OLED (organisches Leuchtemissionsdisplay) aufweist.

26. Vorrichtung nach Anspruch 1 oder Anspruch 7, bei der die Lichtemissionsvorrichtung (34) ein PLED aufweist.

27. Vorrichtung nach Anspruch 7, bei der das Display (10) ein einzelnes Element aufweist, das durch einen einzelnen Hohlraum (18A) definiert wird.

28. Vorrichtung nach Anspruch 7, bei der das Display (10) mehrere Elemente aufweist, die durch mehrere Hohlräume (18A) definiert werden.

29. Vorrichtung nach Anspruch 7, die außerdem mindestens einen Sensor (40) aufweist, der auf dem Substrat montiert ist.

30. Vorrichtung nach Anspruch 6 oder Anspruch 29, bei der der Sensor (40) mindestens eine erste Eleketrode (42) aufweist, die auf dem Substrat (12) angeordnet ist.

31. Vorrichtung nach Anspruch 30, bei der der Sensor (40) außerdem eine zweite Eleketrode (44) aufweist, die auf dem Substrat (12) angeordnet ist.

32. Vorrichtung nach Anspruch 30, bei der der Sensor (40) außerdem ein aktives Bauteil (46) aufweist, das mit der ersten Elektrode (42) elektrisch gekoppelt ist.

33. Vorrichtung nach Anspruch 30, bei der der Sensor (40) außerdem eine integrierte Steuerschaltung (46) aufweist, die mit der ersten Elektrode (42) elektrisch gekoppelt ist.

## Revendications

1. Dispositif d'affichage à profile discret intégré (10), comprenant:
Un substrat (12) ayant une première surface (14) et une seconde surface (16);
Ledit substrat (12) définissant au moins une pénétration (18) traversant ledit substrat depuis ladite première surface jusqu'à ladite seconde surface;
Chacune desdites pénétrations (18) ayant une paroi latérale (24), une ouverture d'entrée (20) définie par ladite première surface, et une ouverture de sortie (22) définie par ladite seconde surface;
Au moins un dispositif électroluminescent (34); et
Un diffuseur de lumière (30) associé avec ladite ouverture de sortie (22) de ladite pénétration ;
Chacun desdits dispositifs électroluminescents étant montés sur ladite première surface (14) dudit substrat (12) à proximité de l'ouverture d'entrée (20) d'une pénétration correspondante (18) et étant adaptés pour admettre de la lumière de manière sélective dans ladite pénétration par ladite ouverture d'entrée; et
Chacun desdits dispositifs électroluminescents (34) étant reliés de manière électrique à un conducteur électrique correspondant disposé sur ledit substrat.

2. Dispositif selon la revendication 1, dans lequel ledit diffuseur (30) comprend une couche de matériau translucide appliquée sur ladite ouverture de sortie.

3. Dispositif selon la revendication 1, dans lequel ledit afficheur (10) comprend un seul élément défini par une seule pénétration (18).

4. Dispositif selon la revendication 1, dans lequel ledit afficheur (10) comprend plusieurs éléments définis par plusieurs pénétrations (18).

5. Dispositif selon la revendication 1, comprenant en outre au moins un composant électronique monté sur ledit substrat (12).

6. Dispositif selon la revendication 5, dans lequel ledit composant électronique comprend un capteur (40).

7. Dispositif d'affichage à profile discret intégré (10), comprenant:
Un substrat (12) ayant une première surface (14) et une seconde surface (16);
Ledit substrat (12) définissant au moins une cavité (18A);
Ladite cavité (18A) ayant une paroi latérale substantiellement opaque (24), une ouverture d'entrée (20) définie par ladite première surface, et une extrémité fermée (32); et
Au moins un dispositif électroluminescent (34);
Chacun desdits dispositifs électroluminescents (34) étant montés sur ladite première surface (14) dudit substrat (12) à proximité de l'ouverture d'entrée (20) d'une cavité correspondante (18A) et étant adaptés pour admettre de la lumière de manière sélective dans ladite cavité par ladite ouverture d'entrée; et chacun desdits dispositifs électroluminescents (34) étant reliés de manière électrique à un conducteur électrique correspondant disposé sur ledit substrat.

8. Dispositif selon la revendication 1 ou la revendication 7, dans lequel l'épaisseur dudit substrat (12) est substantiellement uniforme.

9. Dispositif selon la revendication 1 ou la revendication 7, dans lequel la section transversale dudit substrat (12) varie.

10. Dispositif selon la revendication 1 ou la revendication 7, dans lequel ledit substrat (12) comprend une carte de connexions imprimée (112A).

11. Dispositif selon la revendication 1 ou la revendication 7, dans lequel ledit substrat (12) comprend un tableau d'interface d'utilisateur.

12. Dispositif selon la revendication 1 ou la revendication 7, dans lequel ladite paroi latérale (24) est recouverte d'un matériau substantiellement opaque.

13. Dispositif selon la revendication 12, dans lequel ledit matériau substantiellement opaque est un matériau réfléchissant.

14. Dispositif selon la revendication 13, dans lequel ledit matériau réfléchissant est une peinture.

15. Dispositif selon la revendication 13, dans lequel ledit matériau réfléchissant est un revêtement réfléchissant.

16. Dispositif selon la revendication 1 ou la revendication 7 comprenant en outre un guide lumineux à l'intérieur de ladite pénétration ou cavité.

17. Dispositif selon la revendication 16, dans lequel ledit guide lumineux comprend un matériau ayant un indice de réfraction élevé.

18. Dispositif selon la revendication 17, dans lequel ledit matériau ayant un indice de réfraction élevé comprend une résine époxy translucide.

19. Dispositif selon la revendication 16, dans lequel ledit substrat comprend un matériau substantiellement opaque.

20. Dispositif selon la revendication 16, dans lequel ledit substrat comprend un matériau empêchant substantiellement la transmission de la lumière.

21. Dispositif selon la revendication 7, comprenant en outre un diffuseur de lumière (30) associé à ladite extrémité fermée (12A) de ladite cavité (18A).

22. Dispositif selon la revendication 21, dans lequel ledit diffuseur (30) comprend une couche de matériau translucide appliquée sur ladite extrémité fermée de ladite cavité.

23. Dispositif selon la revendication 1 ou la revendication 7, dans lequel ledit dispositif électroluminescent (34) comprend une diode électroluminescente.

24. Dispositif selon la revendication 1 ou la revendication 7, dans lequel ledit dispositif électroluminescent (34) comprend une lampe.

25. Dispositif selon la revendication 1 ou la revendication 7, dans lequel ledit dispositif électroluminescent (34) comprend une diode électroluminescente organique (OLED).

26. Dispositif selon la revendication 1 ou la revendication 7, dans lequel ledit dispositif électroluminescent (34) comprend un polymère électroluminescent (PLED).

27. Dispositif selon la revendication 7, dans lequel ledit afficheur (10) comprend un seul élément défini par une seule cavité (18A).

28. Dispositif selon la revendication 7, dans lequel ledit afficheur (10) comprend plusieurs éléments définis par plusieurs cavités (18A).

29. Dispositif selon la revendication 7, comprenant en outre au moins un capteur (40) monté sur ledit substrat.

30. Dispositif selon la revendication 6 ou la revendication 29, dans lequel ledit capteur (40) comprend au moins une première électrode (42) disposée sur ledit substrat (12).

31. Dispositif selon la revendication 30, dans lequel ledit capteur (40) comprend en outre une seconde électrode (44) disposée sur ledit substrat (12).

32. Dispositif selon la revendication 30, dans lequel ledit capteur (40) comprend en outre un composant actif (46) couplé de manière électrique à ladite première électrode (42).

33. Dispositif selon la revendication 30, dans lequel ledit capteur (40) comprend en outre un circuit de commande intégré (46) couplé de manière électrique à ladite première électrode (42).
